# EUROPÄISCHE PATENTSCHRIFT

(11) **EP 2 286 257 B1**
(45) Veröffentlichungstag und Bekanntmachung des Hinweises auf die Patenterteilung: **18.01.2012**
(21) Anmeldenummer: 09761515.7
(22) Anmeldetag: 12.06.2009
(51) Int. Cl.: G01R 33/025, H05K 9/00, H05K 5/06

(54) **VERFAHREN ZUR VERBINDUNG HOCHPERMEABLER TEILE EINER MAGNETISCHEN ABSCHIRMUNG**
METHOD FOR COMBINING HIGHLY PERMEABLY PARTS OF A MAGNETIC SHIELD
PROCÉDÉ D'ASSEMBLAGE DE PIÈCES HAUTEMENT PERMÉABLES D'UN BLINDAGE MAGNÉTIQUE

(30) Priorität: 13.06.2008 DE 102008028259
(43) Veröffentlichungstag der Anmeldung: 23.02.2011
(73) Patentinhaber: BMDSys Production GmbH, 39118 Magdeburg (DE)
(72) Erfinder: ERNE, Sergio, Nicola, 89233 Neu-Ulm (DE); NOWAK, Hannes, 07751 Isserstedt (DE); BISON, Georg, 07743 Jena (DE)
(74) Vertreter: Stößel, Matthias
(86) Internationale Anmeldenummer: PCT/EP2009/004260
(87) Internationale Veröffentlichungsnummer: WO 2009/149952

(56) Entgegenhaltungen:
- US-A- 6 048 601
- US-A1- 2006 186 884
- US-B1- 6 419 772

## Beschreibung

### Gebiet der Erfindung

Die Erfindung betrifft ein magnetisches Füllmaterial und eine magnetische Abschirmung. Derartige Füllmaterialien und magnetische Abschirmungen lassen sich insbesondere für biomagnetische Messsysteme einsetzen, insbesondere im Bereich der Magnetokardiologie oder Magnetoneurologie. Auch die Anwendung in anderen Gebieten der Naturwissenschaften, Medizin und Technik ist jedoch grundsätzlich möglich. Weiterhin betrifft die Erfindung ein Verfahren zur Herstellung einer magnetischen Abschirmung sowie ein Verfahren zur Herstellung eines magnetischen Füllmaterials.

### Stand der Technik

In den vergangenen Jahren und Jahrzehnten haben magnetische Messsysteme, welche bis dahin im Wesentlichen der Grundlagenforschung vorbehalten waren, Einzug in viele Bereiche der Technik, der Naturwissenschaften und der Medizin gehalten. Insbesondere die Neurologie und die Kardiologie profitieren von derartigen biomagnetischen Messsystemen. Die vorliegende Erfindung wird, ungeachtet der Möglichkeit des Einsatzes in anderen Gebieten der Naturwissenschaft und Technik und ohne Einschränkung derartiger weiterer Einsatzmöglichkeiten, im Folgenden im Wesentlichen in Bezug auf biomagnetische Messsysteme beschrieben.

Grundlage der biomagnetischen Messsysteme ist die Tatsache, dass die meisten Zellaktivitäten im menschlichen oder tierischen Körper mit elektrischen Signalen, insbesondere elektrischen Strömen, verbunden sind. Die Messung dieser elektrischen Signale selbst, welche durch die Zellaktivität hervorgerufen werden, ist beispielsweise aus dem Bereich der Elektrokardiographie bekannt. Neben den rein elektrischen Signalen sind die elektrischen Ströme jedoch auch mit einem entsprechenden Magnetfeld verbunden, deren Messung sich die verschiedenen bekannten biomagnetischen Messmethoden zunutze machen.

Während die elektrischen Signale bzw. deren Messung außerhalb des Körpers von verschiedenen Faktoren, wie beispielsweise den unterschiedlichen elektrischen Leitfähigkeiten der Gewebetypen zwischen der Quelle und der Körperoberfläche verbunden sind, durchdringen magnetische Signale nahezu ungestört diese Gewebebereiche. Die Messung dieser Magnetfelder und deren Änderungen erlaubt somit Rückschlüsse auf die innerhalb des Gewebes fließenden Ströme, zum Beispiel elektrische Ströme innerhalb des Herzmuskels. Eine Messung dieser magnetischen Felder mit hoher Zeit- und/oder Ortsauflösung über einen gewissen Bereich hinweg erlaubt somit bildgebende Verfahren, welche beispielsweise eine aktuelle Situation verschiedener Bereiche eines menschlichen Herzens wiedergeben können. Andere bekannte Anwendungen liegen beispielsweise im Bereich der Neurologie.

Die Messung von Magnetfeldern biologischer Proben oder Patienten, bzw. die Messung von zeitlichen Änderungen dieser Magnetfelder, stellt jedoch messtechnisch eine hohe Herausforderung dar. So sind beispielsweise die Magnetfeldänderungen im menschlichen Körper, welche bei der Magnetokardiographie zu messen sind, ungefähr eine Million Mal schwächer als das magnetische Feld der Erde. Die Detektion dieser Änderungen erfordert also extrem sensitive Magnetsensoren. In den meisten Fällen werden daher im Bereich der biomagnetischen Messungen supraleitende Quanten-Interferenz-Messgeräte (Superconducting Quantum Interference Devices, SQUIDs) eingesetzt. Derartige Sensoren müssen in der Regel, um den supraleitenden Zustand zu erreichen bzw. aufrechtzuerhalten, typischerweise auf 4 °K (-269 °C) gekühlt werden, wozu üblicherweise flüssiges Helium verwendet wird. Die SQUIDs sind daher in der Regel einzeln oder in einem SQUID-Array in einem Kryostatgefäß (einem sog. Dewar-Gefäß) angeordnet und werden dort entsprechend gekühlt. Alternativ werden zur Zeit Laser-gepumpte magneto-optische Sensoren entwickelt, die annähernd vergleichbare Empfindlichkeit aufweisen können. Auch in diesem Fall werden die Sensoren in der Regel in einer Array-Anordnung in einem Behälter zur Temperaturstabilisierung angeordnet.

Die Messung der extrem schwachen magnetischen Felder bzw. deren Änderungen, welche im Pikotesla- bzw. Sub-Pikoteslabereich liegen, ist naturgemäß extrem empfindlich gegenüber elektromagnetischen und magnetischen Störungen. Die Magnetfelddetektoren, gleich welcher Art, müssen ausgelesen werden, wofür eine Vielzahl elektronischer Vorrichtungen bekannt ist. Diese Ausleseelektronik reagiert jedoch empfindlich gegenüber eingekoppelten fremden elektromagnetischen Feldern, welche starke Störungen verursachen können. Weitere Störungen ergeben sich durch den starken Signalhintergrund äußerer magnetischer Felder, wie insbesondere Mikropulsationen des Erdmagnetfeldes oder anderer magnetischer Felder, insbesondere zeitlich sich verändernder magnetischer Felder, wie sie in der Industriegesellschaft in vielfältiger Weise hervorgerufen werden (z.B. durch Bewegung großer ferromagnetischer Massen, wie beispielsweise Züge, LKWs etc.).

Aus dem Stand der Technik sind verschiedene Ansätze bekannt, das Problem der Störeinflüsse zu lösen. Viele dieser Ansätze beruhen auf einer entsprechenden Abschirmung gegenüber elektromagnetischen und/oder magnetischen Feldern. So sind seit langem aus dem zivilen (z.B. medizinischen) und militärischen Bereich Wirbelstromabschirmungen gegen elektromagnetische Wechselfelder bekannt, welche sowohl stationär als auch beweglich ausgestaltet sein können. Gegen niederfrequente Einflüsse werden in der Regel Abschirmungen aus weichmagnetischen Materialien eingesetzt.

EP 0 359 864 B1 beschreibt eine Einrichtung und ein Verfahren zur Messungen von schwachen, orts- und zeitabhängigen Magnetfeldern. Die Einrichtung umfasst eine Lagerungseinrichtung zur Aufnahme des Untersuchungsobjekts sowie eine Sensoranordnung mit einem SQUID-Array. Weiterhin wird eine magnetische Abschirmkammer beschrieben, welche für magnetische Wechselfelder mit einer Frequenz von 0,5 Hz einen Abschirmfaktor von wenigstens 10, von für magnetische Wechselfelder mit einer Frequenz von 5 Hz einen Abschirmfaktor von wenigstens 100 und für magnetische Wechselfelder mit einer Frequenz von 50 Hz und darüber einen Abschirmfaktor von wenigstens 1000 aufweist. Zudem weist die Abschirmkammer für hochfrequente Wechselfelder (Frequenzen größer als 10 kHz) Abschirmfaktoren von wenigstens 1000 auf.

Ein Nachteil der in EP 0 359 864 B1 beschriebenen Vorrichtung liegt darin, dass trotz der aufwändigen Abschirmung zahlreiche Verbindungen zwischen dem Innenbereich der Abschirmkammer und dem Außenbereich bestehen, welche beispielsweise durch die Durchführung der Halterung der Patientenliege durch die Bodenabschirmung sowie durch weitere zahlreiche durch die Abschirmung durchgeführte Pfosten und elektrische Durchführungen bedingt sind. Diese Durchführungen bewirken jedoch, dass magnetische und elektromagnetische Felder in das Innere der Abschirmkammer eingekoppelt werden und dort die Messung empfindlich beeinträchtigen können.

Diese Nachteile der EP 0 359 864 B1 spiegeln eine allgemeine Problematik wider, welche sich insbesondere bei großvolumigen Abschirmungen von Sensoren und Messgeräten vor dem Einfluss von sowohl statischen als auch niederfrequenten magnetischen Feldern, d.h. Feldern bis zu 10 Hz, stellt. Werden Abschirmelemente in Form von hochpermeablen Materialien, d.h. magnetische Abschirmungen mit Permeabilitäten von mindestens 100 eingesetzt, so werden diese magnetischen Abschirmungen in der Regel aus Einzelteilen zusammengefügt. An den Fügestellen und auch an anderen Öffnungen treten jedoch Schwachpunkte der magnetischen Abschirmungen auf, welche eine hohe Reluktanz aufweisen und somit die Qualität der Abschirmung insgesamt stark vermindern.

Bei kleineren eingeschlossenen Volumina der Abschirmungen werden die Abschirmungen häufig aus einem Stück gefertigt, und die Abschirmleistung entspricht dem typischen Permeabilitätswerten des verwendeten Abschirmmaterials. Bei großen eingeschlossenen Volumina, speziell für begehbare abgeschirmte Räume, wie sie beispielsweise für biomagnetische Messungen eingesetzt werden, werden die Abschirmungen jedoch aus Teilen zusammengesetzt. Der Größe der Abschirmteile sind durch die aufwändige thermische Behandlung Grenzen gesetzt. Bei derartigen aus verschiedenen Teilen zusammengesetzten Abschirmungen entspricht die Abschirmleistung nicht den typischen Permeabilitätswerten des verwendeten Materials, sondern ist kleiner, sodass von einer effektiven Gesamtpermeabilität gesprochen wird. Der Grund für dieses Verhalten sind, wie oben beschrieben, Übergangsbereiche an den Nahtstellen zwischen den verschiedenen Teilen, welche in der Regel aus fertigungstechnischen Gründen nicht schlüssig gefertigt werden können. Insbesondere aufgrund von Verformungen durch thermische Behandlungen bilden sich in aller Regel Luftspalte, die eine hohe Reluktanz zwischen den Teilen bewirken.

Aus US 6,048,601 ist ein weichmagnetisches Legierungspulver für eine elektromagnetische und magnetische Abschirmung bekannt. Weiterhin wird ein Abschirmelement offenbart, welches durch eine Dispersion des Pulvers in einer Matrix aus Gummi oder Kunststoff hergestellt wird. Das weichmagnetische Legierungspulver besteht im Wesentlichen aus 0,5 bis 20 Gew.-% Chrom, 0,01 bis 0,5 Gew.-% Silicium, 0,01 bis 20 Gew.-% Aluminium und ergänzend Eisen und unvermeidlichen Verunreinigungen.

Aus US 6,419,772 B1 ist eine Mikrowellen-Abschirmung bekannt. Dabei werden eine Mehrzahl von Ferritplatten auf einer Abschirmplatte befestigt. Zwischenräume zwischen benachbarten Ferritplatten werden mit einem magnetischen Versiegelungsmittel verschlossen.

Aus US 2006/0186884 A1 ist ein mobiles Gehäuse für ein mobiles MRI-System bekannt. Dies weist eine magnetische Abschirmung in Form einer Mehrzahl von Schichten eines magnetischen Materials auf, welche innerhalb des mobilen Gehäuses mittels einer starren Trägerstruktur gehalten werden.

### Aufgabe der Erfindung

Es ist daher eine Aufgabe der vorliegenden Erfindung, Vorrichtungen und Verfahren zum Abschirmen magnetischer Felder bereitzustellen, welche auch als großvolumige Abschirmungen geeignet sind und welche auch in Öffnungen oder im Übergangsbereich einzelner Abschirmelemente eine geringe Reluktanz aufweisen, so dass insgesamt die Abschirmeigenschaften verbessert werden.

### Beschreibung der Erfindung

Diese Aufgabe der vorliegenden Erfindung wird durch die Vorrichtungen und Verfahren mit den Merkmalen der unabhängigen Ansprüche gelöst. Vorteilhafte Weiterbildungen der Erfindung, welche einzeln oder in Kombination realisierbar sind, sind in den abhängigen Ansprüchen dargestellt.

Im Einzelnen wird vorgeschlagen:
Ein magnetisches Füllmaterial zur Überbrückung von Zwischenräumen in magnetischen Abschirmungen zur Abschirmung statischer oder niederfrequenter magnetischer Felder, wobei das magnetische Füllmaterial mindestens ein Matrixmaterial und mindestens eine in das Matrixmaterial eingebettete magnetische Komponente aufweist, wobei die magnetische Komponente magnetisch abschirmende Eigenschaften aufweist, wobei die magnetische Komponente mindestens ein Material mit einer Permeabilität von mindestens 100 aufweist.

Das Matrixmaterial kann insbesondere im Wesentlichen diamagnetische Eigenschaften aufweisen.

Das Matrixmaterial kann insbesondere mindestens einen verformbaren Zustand und mindestens einen ausgehärteten Zustand aufweisen, wobei das Matrixmaterial in dem verformbaren Zustand flüssig ist oder zumindest teilweise plastische und/oder elastische Eigenschaften aufweist und wobei das Matrixmaterial in dem ausgehärteten Zustand im Wesentlichen starr ist.

Das Matrixmaterial kann insbesondere einen Klebstoff umfassen.

Das Matrixmaterial kann insbesondere mindestens einen der folgenden Stoffe umfassen: ein Harz, insbesondere ein Epoxidharz; einen Mehrkomponenten-Klebstoff oder zumindest eine Komponente eines Mehrkomponenten-Klebstoffs.

Die magnetische Komponente kann insbesondere mindestens ein ferromagnetisches Material aufweisen, insbesondere ein Material mit einer Permeabilität von mindestens 300 und besonders bevorzugt von mindestens 1000.

Die magnetische Komponente kann insbesondere ein metallisches Material umfassen.

Die magnetische Komponenten kann insbesondere mindestens eines der folgenden Materialien umfassen: Eisen; Nickel; eine Legierung mit den Elementen Eisen und Nickel, insbesondere mit einem Nickelanteil zwischen 60% und 90% und besonders bevorzugt zwischen 75% und 80%.

Die magnetische Komponente kann insbesondere in Pulverform oder in Partikelform vorliegen.

Die magnetische Komponente kann insbesondere Partikel mit einer durchschnittlichen Teilchengröße von weniger als 500 µm, insbesondere weniger als 90 µm und besonders bevorzugt von 60 µm aufweisen.

Die magnetische Komponente kann insbesondere einen Massenanteil von 5-50 Gew.%, insbesondere 15 Gew.%, an dem magnetischen Füllmaterial aufweisen.

Die magnetische Komponenten kann insbesondere einen Volumenanteil von 1-30 Vol.-% an dem magnetischen Füllmaterial aufweisen.

Weiterhin wird eine magnetische Abschirmung zur Abschirmung statischer oder niederequenter magnetischer Felder vorgeschlagen, umfassend mindestens ein Abschirmelement mit magnetisch abschirmenden Eigenschaften, wobei das Abschirmelement mindestens eine Öffnung aufweist, wobei zur Verstärkung der magnetischen Abschirmung mindestens ein magnetisches Füllmaterial gemäß einer oder mehreren der oben beschriebenen Ausgestaltungen in die Öffnungen eingebracht ist.

Das mindestens eine Abschirmelement kann insbesondere mindestens zwei Abschirmelemente umfassen, wobei die Öffnung mindestens einen Verbindungsbereich umfasst, wobei die Abschirmelemente in dem Verbindungsbereich miteinander verbunden sind, wobei zur Verstärkung der magnetischen Abschirmung das magnetische Füllmaterial in den Verbindungsbereich eingebracht ist.

Die Öffnung kann insbesondere mindestens eines der folgenden Elemente umfassen: eine Durchführung; eine Fügestelle; eine Nahtstelle; eine Stoßfuge.

Die Abschirmelemente können insbesondere mindestens ein metallisches Material umfassen, insbesondere mindestens eines der folgenden Materialien: Eisen; Nickel; eine Legierung mit den Elementen Eisen und Nickel, insbesondere mit einem Nickelanteil zwischen 60% und 90% und besonders bevorzugt zwischen 75% und 80%.

Die Abschirmelemente können insbesondere zumindest teilweise im Wesentlichen als plattenförmige Elemente ausgestaltet sein.

Die Abschirmelemente können insbesondere eine Permeabilität von mindestens 100 aufweisen.

Die magnetische Abschirmung kann insbesondere im Wesentlichen eine Quaderform aufweisen.

Die magnetische Abschirmung kann insbesondere einen Innenraum von mindestens 1 m³ umschließen, vorzugsweise einen begehbaren Innenraum.

Weiterhin wird ein biomagnetisches Messsystems für den Einsatz in der Magnetokardiologie oder der Magnetoneurologie vorgeschlagen, umfassend mindestens ein magnetisches Sensorsystem zur Erfassung mindestens eines Magnetfeldes, weiterhin umfassend mindestens eine magnetische Abschirmung gemäß einer oder mehreren der oben beschriebenen Ausgestaltungen.

Weiterhin wird ein Verfahren zur Herstellung einer magnetischen Abschirmung gemäß einer oder mehreren der oben beschriebenen Ausgestaltungen vorgeschlagen, wobei zunächst mindestens zwei Abschirmelemente miteinander mechanisch verbunden werden, wobei der mindestens eine Verbindungsbereich gebildet wird, wobei anschließend das magnetische Füllmaterial in den Verbindungsbereich eingebracht wird.

Das magnetische Füllmaterials kann insbesondere in einem verformbaren Zustand in den Verbindungsbereich eingebracht werden, wobei das magnetische Füllmaterial anschließend ausgehärtet wird.

Die Abschirmelemente können insbesondere durch mindestens eine der folgenden Verbindungsarten miteinander verbunden werden: eine kraftschlüssige und/oder formschlüssige Verbindung, insbesondere eine Steckverbindung; eine stoffschlüssig Verbindung, insbesondere eine Schweißverbindung.

Weiterhin wird ein Verfahren zur Herstellung eines magnetischen Füllmaterials gemäß einer oder mehreren der oben beschriebenen Ausgestaltungen vorgeschlagen, umfassend die folgenden Schritte:
- Das mindestens eine Matrixmaterial wird bereitgestellt;
- die mindestens eine magnetische Komponente wird in das Matrixmaterial eingemischt

Ein Gedanke der vorliegenden Erfindung besteht darin, eine magnetische Abschirmung gegen statische und niederfrequente magnetische Felder, d.h. Felder mit Frequenzen von maximal 10 Hz, durch magnetische Abschirmelemente bereitzustellen. Diese Abschirmelemente können in einem Verbindungsbereich miteinander verbunden sein oder können andere Arten von Öffnungen aufweisen. Insbesondere lassen sich als Abschirmungen hochpermeable Materialien, also Materialien mit einer Permeabilität von mindestens 100, einsetzen. Zur Vermeidung hoher Reluktanzen in den Verbindungsbereichen zwischen den Abschirmelementen oder in anderen Arten von Öffnungen wird erfindungsgemäß vorgeschlagen, ein Füllmaterial einzubringen, welches ein Matrixmaterial, das die Formstabilität gewährleistet, und eine magnetische Komponente aufweist. Auf diese Weise können mindestens eine oder alle Öffnungen magnetisch verschlossen werden.

In einem ersten Aspekt der vorliegenden Erfindung wird daher ein magnetisches Füllmaterial vorgeschlagen, welches sich insbesondere für die Abschirmung von Verfugungen oder anderen Verbindungsbereichen oder Öffnungen in oder zwischen den Abschirmelementen magnetischer Abschirmungen einsetzen lässt. Allgemein ist das magnetische Füllmaterial zur Überbrückung von Öffnungen in magnetischen Abschirmungen zur Abschirmung statischer oder niederfrequenter magnetischer Felder geeignet, d.h. magnetischer Felder mit einer Frequenz von bis zu 10 Hz. Das magnetische Füllmaterial umfasst mindestens ein Matrixmaterial, also ein Trägermaterial, welches im Wesentlichen die Form und die mechanischen Eigenschaften der mittels des magnetischen Füllmaterials hergestellten magnetischen Füllungen in den Zwischenräumen bestimmt. Daneben umfasst das magnetische Füllmaterial mindestens eine in das Matrixmaterial eingebettete magnetische Komponente, welche magnetisch abschirmende Eigenschaften aufweist.

Das Matrixmaterial kann insbesondere im Wesentlichen nicht-magnetische oder diamagnetische oder paramagnetische Eigenschaften aufweisen. Weiterhin kann das Matrixmaterial mindestens einen verformbaren Zustand und mindestens einen ausgehärteten Zustand aufweisen, also ein zumindest teilweise aushärtbares Matrixmaterial sein. Dabei ist das Matrixmaterial in dem verformbaren Zustand flüssig oder weist zumindest teilweise plastische und/oder elastische Eigenschaften auf. Beispielsweise kann das Matrixmaterial in dem verformbaren Zustand eine pastöse Form aufweisen und/oder eine Viskosität von mindestens 100 mPas, vorzugsweise mindestens 1000 mPas. In dem ausgehärteten Zustand soll das magnetische Füllmaterial hingegen unter den üblicherweise im Betrieb auftretenden Kräften, insbesondere unter Einfluss der eigenen Gewichtskraft, im Wesentlichen formstabil sein und soll vorzugsweise mechanisch tragende Eigenschaften aufweisen. In anderen Worten soll das Matrixmaterial vorzugsweise ein aushärtbares Matrixmaterial sein oder ein derartiges aushärtbares Matrixmaterial umfassen, wobei von diesem Begriff auch die Situation erfasst sein soll, dass das ausgehärtete Matrixmaterial auch noch zumindest leicht plastische und/oder elastische Eigenschaften aufweist.

So kann beispielsweise das Matrixmaterial einen Klebstoff umfassen, also ein Material mit adhesiven Eigenschaften. Hierfür können sowohl Einkomponenten- als auch Mehrkomponenten-Klebstoffe eingesetzt werden. Weiterhin lassen sich allgemein Harze, insbesondere Epoxidharze, ohne oder speziell mit Klebeeigenschaften, Mehrkomponenten-Klebstoffe oder zumindest eine Komponente eines Mehrkomponenten-Klebstoffs einsetzen.

Wird ein aushärtbares Matrixmaterial verwendet, so kann die Aushärtung auf verschiedene Weise erfolgen. Beispielsweise kann eine photochemische Aushärtung und/oder eine thermische Aushärtung erfolgen. Auch die Beimischung eines Härters kann realisiert werden. In diesem Fall kann beispielsweise das Matrixmaterial die Hauptkomponente des Mehrkomponenten-Klebstoffs umfassen, wohingegen der Härter erst später hinzugefügt wird, oder umgekehrt. Alternativ kann der Härter auch ganz oder teilweise Bestandteil des Matrixmaterials sein.

Diese viskosen, aushärtbaren Matrixmaterialien stehen im Unterschied zu den ebenfalls grundsätzlich einsetzbaren Ferrofluiden, kolloidalen Suspensionen von Nanoteilchen wie beispielsweise Eisen oder Nickel. Derartige Ferrofluide sind bestenfalls superparamagnetisch, weisen also keine ausreichende Permeabilität auf, und verfügen in der Regel weder über die erforderliche Langzeitstabilität noch lassen sich diese wegen ihrer geringen Viskosität gezielt platzieren, beispielsweise an Nahtstellen zwischen Abschirmelementen.

Die magnetische Komponente weist magnetisch abschirmende Eigenschaften auf. Zu diesem Zweck kann die magnetische Komponente insbesondere mindestens ein Material aufweisen, das eine Permeabilität von mindestens 10, vorzugsweise von mindestens 100, insbesondere mindestens 300 und besonders bevorzugt von mindestens 1000 aufweist. Insbesondere lassen sich als magnetische Komponente metallische Materialien einsetzen. Beispielsweise lassen sich Eisen, Nickel, Nickel-Eisen-Legierungen oder ähnliche Materialien einsetzen. Insbesondere können Eisen-Nickel-Legierungen mit einem Nickelanteil zwischen 60% und 90%, besonders bevorzugt zwischen 75% und 80%, eingesetzt werden. Derartige Materialien sind als so genannte "Mu-Metalle" beispielsweise in Platten-, Granulat- oder Pulverform kommerziell erhältlich und können erfindungsgemäß als magnetische Komponente, eingebettet in dem Matrixmaterial, eingesetzt werden.

Besonders bevorzugt ist es, wenn die magnetische Komponente in Pulverform oder in Partikelform vorliegt, wobei dieses Pulver und/oder die Partikel in dem Matrixmaterial eingebettet sind, beispielsweise durch Dispergieren, Vermischen oder ähnliches. Besonders bevorzugt ist es, wenn die magnetische Komponente Partikel mit einer durchschnittlichen Teilchengröße von weniger als 500 Mikrometern, insbesondere von weniger als 400 Mikrometern, insbesondere von weniger als 90 Mikrometern und besonders bevorzugt von ca. 60 Mikrometern aufweist. Auch die maximalen Teilchengrößen sollten vorzugsweise unterhalb von 500 Mikrometern liegen, besonders bevorzugt unterhalb von 100 Mikrometern.

Die magnetische Komponente kann insbesondere einen Massenanteil von 5 bis 50 Gew.-%, insbesondere 10 bis 30 Gew.-% und besonders bevorzugt ca. 15 Gew.-% an dem magnetischen Füllmaterial aufweisen und/oder einen Volumenanteil von ca. 1-30 Vol.-% an dem magnetischen Füllmaterial.

Wie oben beschrieben, lässt sich das magnetische Füllmaterial insbesondere im Rahmen magnetischer Abschirmung zur Abschirmung statischer oder niederfrequenter magnetischer Felder einsetzen. Die vorgeschlagene magnetische Abschirmung umfasst mindestens ein Abschirmelement mit magnetisch abschirmenden Eigenschaften, vorzugsweise wiederum mit Permeabilitäten von mindestens 10, vorzugsweise mindestens 100 oder sogar mindestens 300 und besonders bevorzugt mindestens 1000. Dieses Abschirmelement weist mindestens eine Öffnung auf, wobei zur Verstärkung der magnetischen Abschirmung mindestens ein magnetisches Füllmaterial gemäß einer oder mehreren der oben beschriebenen Ausführungsformen in die Öffnung eingebracht ist. Sind mehrere Öffnungen vorhanden, so kann das magnetische Füllmaterial in eine, mehrere oder alle dieser Öffnungen eingebracht sein. Die Öffnung kann auch am Rand des mindestens einen Abschirmelements oder zwischen zwei Teil-Abschirmelementen vorgesehen sein, welche gemeinsam wiederum zu einem Abschirmelement zusammengefügt sind.

Besonders bevorzugt ist es, wie oben beschrieben, wenn die magnetische Abschirmung modular aus mehreren Abschirmelementen zusammengesetzt ist, da sich auf diese Weise auch großvolumige Abschirmungen realisieren lassen. Dementsprechend ist es bevorzugt, wenn die magnetische Abschirmung mindestens zwei Abschirmelemente mit magnetisch abschirmenden Eigenschaften aufweist. Die Abschirmelemente sind in mindestens einem Verbindungsbereich miteinander verbunden. Zur Verstärkung der magnetischen Abschirmung ist in dem Verbindungsbereich mindestens ein magnetisches Füllmaterial gemäß einer oder mehrer der oben beschriebenen Ausführungsformen eingebracht.

Auch in anderen Bereichen, in welchen in oder zwischen den Abschirmelementen und/oder innerhalb eines Abschirmelements unerwünschte Öffnungen auftreten, beispielsweise im Bereich von Durchführungen oder ähnlichem, kann das magnetische Füllmaterial eingebracht werden. Allgemein kann die mindestens eine Öffnung alternativ oder zusätzlich zu Verbindungsbereichen insbesondere eine Durchführung, eine Fügestelle, eine Nahtstelle eine Stoßfuge oder Kombinationen der genannten Öffnungen und/oder weiterer Arten von Öffnungen umfassen. Der Begriff der Öffnung ist somit allgemein weit zu fassen und umfasst jegliche Art von Unterbrechung der magnetischen Abschirmelemente, in denen die magnetische Abschirmung geschwächt ist.

Die Abschirmelemente können mindestens ein metallisches Material umfassen, beispielsweise wiederum ein metallisches Material mit einer Permeabilität von mindestens 10, vorzugsweise einer Permeabilität von mindestens 100 oder sogar 300 und besonders bevorzugt mit einer Permeabilität von mindestens 1000. Zu diesem Zweck lassen sich beispielsweise wiederum Eisen, Nickel, Legierungen dieser Elemente und besonders bevorzugt wiederum so genannte Mu-Metalle einsetzen. Die Abschirmelemente können beispielsweise im Wesentlichen als plattenförmige Elemente ausgestaltet sein, so dass sich die magnetische Abschirmung aus einzelnen Platten der Abschirmelemente zusammensetzen lässt. Auch zusätzliche Abschirmelemente in Form von Verbindungsteilen wie Winkeln, Ecken oder ähnlichem sind jedoch selbstverständlich möglich. Insgesamt kann die magnetische Abschirmung beispielsweise im Wesentlichen eine Quaderform aufweisen, wobei das magnetische Füllmaterial insbesondere an den Kanten und/oder Ecken des Quaders eingebracht werden kann. Wie oben beschrieben, machen sich die Formteile des magnetischen Füllmaterials insbesondere bei großvolumigen, nicht aus einem Stück fertigbaren magnetischen Abschirmungen bemerkbar, so dass es besonders bevorzugt ist, wenn die magnetische Abschirmung im Rahmen der vorliegenden Erfindung einen Innenraum von mindestens 1 m³ umschließt. Insbesondere kann dieser Innenraum als begehbarer Innenraum ausgestaltet sein, also beispielsweise als Innenraum mit mindestens einer Zugangstür, in welchem sich mindestens eine Person aufhalten kann.

Neben dem magnetischen Füllmaterial und der magnetischen Abschirmung in einer der oben beschriebenen Ausführungsformen wird weiterhin ein biomagnetisches Messsystem im Sinne der obigen Beschreibung derartige biomagnetischer Messsysteme vorgeschlagen. Insbesondere lässt sich das vorgeschlagene Messsystem in der Magnetokardiologie oder in Magnetoneurologie einsetzen, wobei jedoch andere Einsatzgebiete denkbar sind, beispielsweise in anderen Bereich der Naturwissenschaften, der Technik oder der Medizin. Das biomagnetische Messsystem umfasst dementsprechend mindestens ein magnetisches Sensorsystem zur Erfassung mindestens eines Magnetfelds. Beispielsweise kann dieses magnetische Sensorsystem ein SQUID-Array und/oder andere Arten biomagnetischer Messsysteme umfassen, beispielsweise magneto-opische Sensoren.

Weiterhin umfasst das vorgeschlagene biomagnetische Messsystem mindestens eine magnetische Abschirmung gemäß einer oder mehrerer der oben beschriebenen Ausführungsformen. Daneben kann das biomagnetische Messsystem weitere Komponenten umfassen. Beispielsweise können Auswertesysteme für das magnetische Sensorsystem vorgesehen sein, beispielsweise elektronische Auswertesysteme und/oder Datenverarbeitungssysteme. Auch Energiequellen, Positionierungseinrichtungen für Patienten oder ähnliches können vorgesehen sein, welche, wie auch das magnetische Sensorsystem, insbesondere in einem Innenraum der magnetischen Abschirmung angeordnet sein können, beispielsweise einer magnetischen Patientenkammer, welche die magnetische Abschirmung umfasst.

Neben dem biomagnetischen Messsystem wird weiterhin ein Verfahren zur Herstellung einer magnetischen Abschirmung gemäß einer oder mehrerer der oben beschriebenen Ausführungsformen vorgeschlagen. Dabei werden zunächst mindestens zwei Abschirmelemente miteinander mechanisch verbunden, also derart verbunden, dass die magnetische Abschirmung als solche bereits im Wesentlichen formstabil ist. Hierbei bildet sich der mindestens eine Verbindungsbereich, beispielsweise in Form von Stoßfugen. Anschließend wird das magnetische Füllmaterial in diesen Verbindungsbereich eingebracht. Dieses Einbringen kann insbesondere in einem verformbaren Zustand erfolgen, und anschließend kann eine Aushärtung des magnetischen Füllmaterials erfolgen, beispielsweise durch einfaches Zuwarten, durch thermische Einwirkung, durch Lichteinwirkung oder durch (was bereits vor dem Einbringen des magnetischen Füllmaterials erfolgen kann) Einbringen eines zusätzlichen chemischen Härters.

Die mindestens zwei Abschirmelemente können insbesondere durch kraftschlüssige und/oder formschlüssige Verbindungen miteinander verbunden werden, insbesondere durch Steckverbindungen. Auch andere Arten der Verbindung sind jedoch grundsätzlich möglich, beispielsweise stoffschlüssige Verbindungen, insbesondere Schweißverbindungen.

Weiterhin wird ein Verfahren zur Herstellung eines magnetischen Füllmaterials gemäß einer oder mehrerer der oben beschriebenen Ausführungsformen vorgeschlagen. Zu diesem Zweck wird zunächst das mindestens eine Matrixmaterial bereitgestellt, welches vorzugsweise flüssig und/oder pastös ist, also nach wie vor verformbar. In dieses mindestens eine Matrixmaterial wird dann die mindestens eine magnetische Komponente eingemischt. Wie oben beschrieben, kann dies beispielsweise in Pulver- oder Partikelform erfolgen. Das Einmischen kann beispielsweise durch Rühren oder andere Arten einer Dispergierung erfolgen. Auch ein Einkneten ist denkbar.

### Ausführungsbeispiele

Weitere Einzelheiten und Merkmale der Erfindung ergeben sich aus der nachfolgenden Beschreibung von bevorzugten Ausführungsbeispielen in Verbindung mit den Unteransprüchen. Hierbei können die jeweiligen Merkmale für sich alleine oder zu mehreren in Kombination miteinander verwirklicht sein. Die Erfindung ist nicht auf die Ausführungsbeispiele beschränkt. Die Ausführungsbeispiele sind in den Figuren schematisch dargestellt. Gleiche Bezugsziffern in den einzelnen Figuren bezeichnen dabei gleiche oder funktionsgleiche bzw. hinsichtlich ihrer Funktionen einander entsprechende Elemente.

Im Einzelnen zeigt:
- Figuren 1A und 1B: eine magnetische Abschirmung sowie ein Verfahren zur Herstellung der magnetischen Abschirmung,
- Figur 2: ein biomagnetisches Messsystem und
- Figur 3: ein Verfahren zur Herstellung eines magnetischen Füllmaterials.

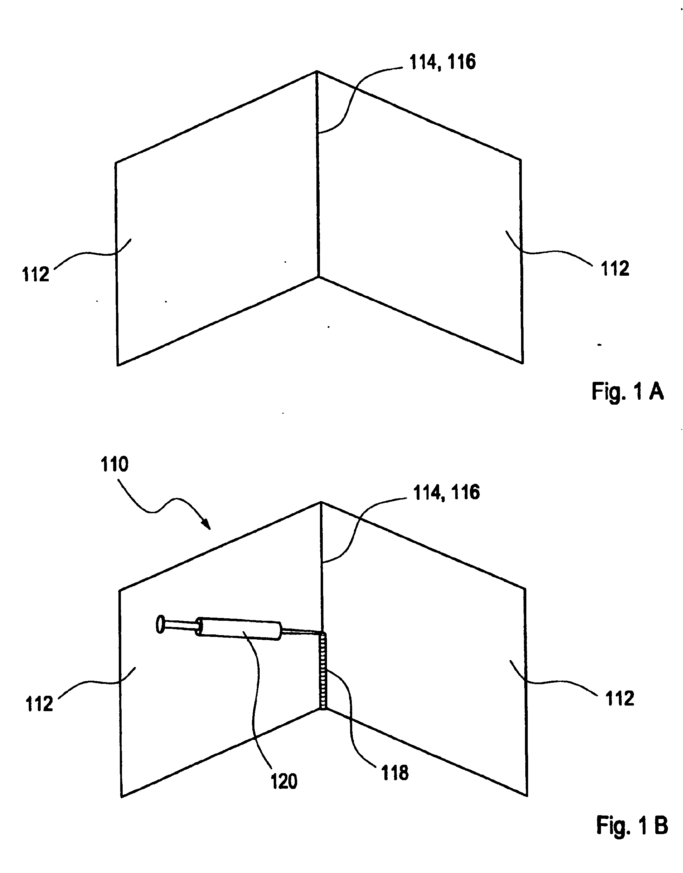

In Figuren 1A und 1B ist in stark schematisierter Form ein Verfahren zur Herstellung einer magnetischen Abschirmung (in Figur 1B mit der Bezugsziffer 110 bezeichnet) dargestellt. In einem ersten, in Figur 1B dargestellten Verfahrensschritt werden hierfür zwei Abschirmelemente 112 zusammengefügt. Diese Abschirmelemente 112 sind in dem dargestellten Ausführungsbeispiel als Platten ausgebildet, beispielsweise als Platten einer Eisen-Nickel-Legierung mit einer Dicke zwischen beispielsweise 1 und 5 mm. Die Abschirmelemente 112 können beispielsweise eine Permeabilität von 300 oder mehr aufweisen.

Die Abschirmelemente 112 werden entlang einer Stoßfuge 114 mechanisch miteinander verbunden. Beispielsweise kann diese mechanische Verbindung durch Punktschweißen und/oder durch Verwendung von Verbindungselementen erfolgen, wie beispielsweise Klammern, in den Abschirmelementen 112 ausgebildeten Verbindungselementen oder ähnliches. Beispielsweise kann auch eine Steckverbindung gewählt werden. Die Stoßfuge 114 bildet somit einen Verbindungsbereich 116 als Beispiel einer Öffnung, in welcher die magnetische Abschirmung 110 durch die Abschirmelemente 112 lokal unterbrochen ist.

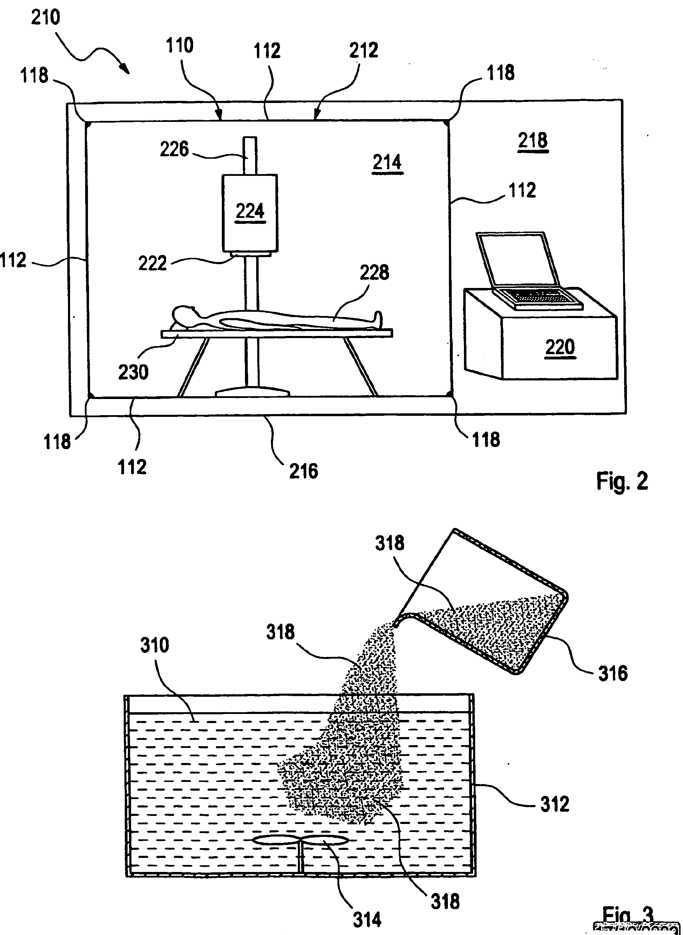

In einem zweiten, in Figur 1B dargestellten Verfahrensschritt wird daher dieser Verbindungsbereich 116 möglichst vollständig durch ein magnetisches Füllmaterial 118 abgedichtet Dieses magnetische Füllmaterial kann beispielsweise, wie in Figur 1B dargestellt, mittels einer Spritze 120 von der Innenseite und/oder der Außenseite auf die Stoßfuge 114 aufgebracht werden. Auch andere Arten der Einbringung sind möglich, beispielsweise ein Spachteln, ein Sprühen, ein Streichen oder ähnliches. Zum Zweck des Einbringens ist das magnetische Füllmaterial 118 zunächst vorzugsweise verformbar ausgestaltet, beispielsweise als Paste. Auf Einzelheiten der möglichen Ausgestaltung des magnetischen Füllmaterials wird unten am Beispiel der Figur 3 näher eingegangen. Auf diese Weise lässt sich durch das in Figur 1B schematisch dargestellte Verfahren eine magnetisch "dichte" Abschirmung herstellen, bei welcher auch der bzw. die Verbindungsbereiche 116 durch das magnetische Füllmaterial 118 magnetisch abgeschirmt sind.

Da die magnetischen Abschirmungen 110 gemäß dem erfindungsgemäßen Verfahren nunmehr, ohne Beeinträchtigung durch Verbindungsbereiche, hochgradig modular aufgebaut sein können, können auch magnetische Abschirmungen 110 mit einem großvolumigen Innenraum hergestellt werden. Dementsprechend ist in Figur 2 ein Ausführungsbeispiel eines biomagnetischen Messsystems 210 gezeigt, welches eine Patientenkammer 212 mit einer erfindungsgemäßen magnetischen Abschirmung 110 und einem begehbaren Innenraum 214 umfasst.

Das biomagnetische Messsystem 210 umfasst in dem dargestellten Ausführungsbeispiel einen Messcontainer 216, welcher beispielsweise über eine Abschirmung gegen elektromagnetische Hochfrequenzfelder verfügt. In diesem Messcontainer 216 ist zunächst eine Vorkammer 218 vorgesehen. In dieser Vorkammer 218 kann beispielsweise ein Teil der Ansteuer- und Auswertungselektronik 220 des biomagnetischen Messsystems 210 aufgenommen sein, beispielsweise eine Bedienerkonsole. Weitere Teile der Ansteuer- und Auswertungselektronik 220 können optional im Innenraum 214 und/oder außerhalb des Messcontainers 216 vorgesehen sein. Die Ansteuer- und Auswertungselektronik 220 kann beispielsweise ein oder mehrere Computersysteme sowie weitere elektronische Komponenten umfassen.

Neben der Vorkammer 218, welche beispielsweise durch eine in Figur 2 nicht dargestellte Außentür von außen begehbar sein kann, ist im Inneren des Messcontainers 216 die Patientenkammer 212 aufgenommen. Auch hier kann beispielsweise eine Türverbindung zwischen der Vorkammer 218 und dem Innenraum 214 vorgesehen sein, welche ebenfalls in Figur 2 nicht dargestellt ist.

Im Innenraum 214 der Patientenkammer 212 ist ein magnetisches Sensorsystem 222 vorgesehen. Diese magnetische Sensorsystem 222 kann beispielsweise ein SQUID-Array umfassen, welches beispielsweise in einem Dewar-Gefäß 224 gekühlt gelagert ist und welches beispielsweise an einer Aufhängevorrichtung 226 höhenverstellbar gelagert ist.

Mittels des magnetischen Sensorsystems 222 lassen sich beispielsweise Herzströme eines auf einer Patientenliege 230 gelagerten Patienten 228 aufnehmen. Zur Abschirmung des magnetischen Sensorsystems 222 gegenüber statischen oder niederfrequenten magnetischen Feldern ist die Patientenkammer 212 bzw. deren Innenraum 214 durch die magnetische Abschirmung 110 umgeben. Diese magnetische Abschirmung ist in diesem Fall beispielsweise quaderförmig ausgestaltet und umfasst wiederum beispielsweise plattenförmige Abschirmelemente 112, sowie, analog zu Figur 1B, in den Verbindungsbereichen dieser Abschirmelemente 112 magnetische Füllmaterialien 118. Alternativ oder zusätzlich können auch andere Arten von Öffnungen durch dieses magnetische Füllmaterial 118 abgedichtet sein, beispielsweise Kabeldurchführungen von der Vorkammer 218 in den Innenraum 214, beispielsweise für Steuerleitungen oder Signalleitungen des magnetischen Sensorsystems.

In Figur 3 ist symbolisch ein Herstellungsverfahren zur Herstellung eines magnetischen Füllmaterials 118 dargestellt. Bei diesem Verfahren liegt zunächst ein Matrixmaterial 310 in flüssiger und/oder anderweitig verformbarer Form in einem Mischgefäß 312 vor. Das Mischgefäß 312 verfügt über eine Rühreinrichtung 314, welche in Fig. 3 lediglich symbolisch angedeutet ist. Auch andere Arten von Dispergiervorrichtungen sind grundsätzlich möglich, neben der Rühreinrichtung 314 können, ebenfalls optional, beispielsweise auch Temperiervorrichtungen oder ähnliches vorliegen, um durch eine Erhöhung der Temperatur beispielsweise die Viskosität des Matrixmaterials 312 zu erniedrigen.

Wie in Figur 3 anhand des Schüttgefäßes 316 symbolisch angedeutet, wird in einem nächsten Verfahrensschritt dem Matrixmaterial 310 eine magnetische Komponente 318 beigemischt, indem diese beispielsweise dem Matrixmaterial 310 unter Rühren zugegeben wird.

Die magnetische Komponente 318 liegt vorzugsweise in Pulverform vor. Als besonders geeignet haben sich Eisenpulver oder Nickelpulver oder andere ferromagnetische Materialien oder Gemische daraus mit geringer Teilchengröße erwiesen, bevorzugt mit Teilchengrößen unterhalb von 400 Mikrometern, vorzugsweise kleiner als 90 Mikrometern oder mit einem durchschnittlichen Durchmesser von 60 Mikrometern.

Im Folgenden wird beispielhaft eine Mischung angegeben, welche zur Herstellung eines magnetischen Füllmaterials 118 verwendet wurde:

### Beispiel 1:

In einem ersten Ausführungsbeispiel wurde als Matrixmaterial ein Epoxidharz vom Typ Loctite Hysol 9496 der Henkel AG und & Co. KGaA in Düsseldorf, Deutschland, verwendet. Dieses Matrixmaterial umfasst als erste Komponente ein Epoxidharz mit einer Viskosität von mehr als 10.000 mPas und als zweite Komponente ein Amin mit einer Viskosität von über 200 mPas. Sechs Volumen-% der ersten Komponente wurden ca. ein Vol.-% der zweiten Komponente (Härter) beigemischt. Das gemischte Matrixmaterial weist eine Viskosität von ca. 2.600 mPas auf.

Zur Herstellung des magnetischen Füllmaterials 118 in einem ersten Beispiel wurde der genannten ersten Komponente (Epoxidkomponente) des Matrixmaterials 310 als magnetische Komponente 318 Eisenpulver beigemengt. Zu diesem Zweck wurde Eisenpulver vom Typ FE006010 der Firma Goodfellow GmbH in Friedberg, Deutschland, verwendet. Dieses Eisenpulver weist eine Reinheit von mindestens 99,0% auf sowie eine maximale Teilchengröße von 450 Mikrometern. Dieses Eisenpulver als magnetische Komponente 318 wurde der ersten Komponente des Matrixmaterials 310 in einer Konzentration von 15 Gew.-% unter Rühren beigemischt. Kurz vor der Verarbeitung des magnetischen Füllmaterials wurde schließlich dieser Mischung die zweite Komponente (Härter) des Matrixmaterials beigemischt, und das derartig erzeugte magnetische Füllmaterial verarbeitet.

Das derartig erzeugte Füllmaterial 118 wurde in verschiedenen magnetischen Abschirmungen 110 eingesetzt. Es ließ sich hierbei an den Übergangsstellen zwischen einzelnen Abschirmelementen 112 eine deutlich verringerte Reluktanz nachweisen, was die Funktionalität der vorgeschlagenen Mischung belegte.

### Beispiel 2:

In einem zweiten Ausführungsbeispiel wurde im Wesentlichen die im Beispiel 1 beschriebene Mischung verwendet. Anstelle von Eisenpulver des Typs FE006010 wurde jedoch in diesem Ausführungsbeispiel Eisenpulver des Typs FE006020, ebenfalls der Firma Goodfellow GmbH in Friedberg, Deutschland, eingesetzt. Dieses Eisenpulver weist eine maximale Teilchengröße von 60 Mikrometern und eine Reinheit von ebenfalls mindestens 99,0% auf. Die Herstellung des magnetischen Füllmaterials 118 erfolgte ansonsten im Wesentlichen analog zu Beispiel 1.

### Bezugszeichenliste

- 110: magnetische Abschirmung
- 112: Abschirmelement
- 114: Stoßfuge
- 116: Verbindungsbereich
- 118: magnetisches Füllmaterial
- 120: Spritze
- 210: biomagnetisches Messsystem
- 212: Patientenkammer
- 214: Innenraum
- 216: Messcontainer
- 218: Vorkammer
- 220: Ansteuer- und Auswertungselektronik
- 222: magnetisches Sensorsystem
- 224: Dewar-Gefäß
- 226: Aufhängevorrichtung
- 228: Patient
- 230: Patientenliege
- 310: Matrixmaterial
- 312: Mischgefäß
- 314: Rühreinrichtung
- 316: Schüttgefäß
- 318: magnetische Komponente

## Patentansprüche

1. Magnetisches Füllmaterial (118) zur Überbrückung von Zwischenräumen (114, 118) in magnetischen Abschirmungen und zur Abschirmung statischer oder niederfrequenter magnetischer Felder, wobei das magnetische Füllmaterial (118) mindestens ein Matrixmaterial (310) und mindestens eine in das Matrixmaterial (310) eingebettete magnetische Komponente (318) aufweist, wobei die magnetische Komponente (318) magnetisch abschirmende Eigenschaften aufweist, wobei die magnetische Komponente (318) mindestens ein Material mit einer Permeabilität von mindestens 100 aufweist.

2. Magnetisches Füllmaterial (118) nach dem vorhergehenden Anspruch, wobei das Matrixmaterial (310) im Wesentlichen diamagnetische Eigenschaften aufweist.

3. Magnetisches Füllmaterial (118) nach einem der vorhergehenden Ansprüche, wobei das Matrixmaterial (310) mindestens einen verformbaren Zustand und mindestens einen ausgehärteten Zustand aufweist, wobei das Matrixmaterial (310) in dem verformbaren Zustand flüssig ist oder zumindest teilweise plastische und/oder elastische Eigenschaften aufweist und wobei das Matrixmaterial (310) in dem ausgehärteten Zustand im Wesentlichen starr ist.

4. Magnetisches Füllmaterial (118) nach einem der vorhergehenden Ansprüche, wobei die magnetische Komponente (318) mindestens ein ferromagnetisches Material aufweist, insbesondere ein Material mit einer Permeabilität von mindestens 300 und besonders bevorzugt von mindestens 1000.

5. Magnetisches Füllmaterial (118) nach einem der vorhergehenden Ansprüche, wobei die magnetische Komponente (318) mindestens eines der folgenden Materialien umfasst: Eisen; Nickel; eine Legierung mit den Elementen Eisen und Nickel, insbesondere mit einem Nickelanteil zwischen 60% und 90% und besonders bevorzugt zwischen 75% und 80%.

6. Magnetisches Füllmaterial (118) nach einem der vorhergehenden Ansprüche, wobei die magnetische Komponente (318) in Pulverform oder in Partikelform vorliegt.

7. Magnetisches Füllmaterial (118) nach dem vorhergehenden Anspruch, wobei die magnetische Komponente (318) Partikel mit einer durchschnittlichen Teilchengröße von weniger als 500 Mikrometern, insbesondere weniger als 90 Mikrometern und besonders bevorzugt von 60 Mikrometern aufweist.

8. Magnetisches Füllmaterial (118) nach einem der vorhergehenden Ansprüche, wobei die magnetische Komponente (318) einen Massenanteil von 5 bis 50 Gewichtsprozent, insbesondere 15 Gewichtsprozent, an dem magnetischen Füllmaterial (118) aufweist.

9. Magnetisches Füllmaterial (118) nach einem der vorhergehenden Ansprüche, wobei die magnetische Komponente (318) einen Volumenanteil von 1 bis 30 Volumenprozent an dem magnetischen Füllmaterial (118) aufweist.

10. Magnetische Abschirmung (110) zur Abschirmung statischer oder niederfrequenter magnetischer Felder, umfassend mindestens ein Abschirmelement (112) mit magnetisch abschirmenden Eigenschaften, wobei das Abschirmelement (112) mindestens eine Öffnung (114, 116) aufweist, wobei zur Verstärkung der magnetischen Abschirmung (110) mindestens ein magnetisches Füllmaterial (118) gemäß einem der vorhergehenden Ansprüche in die Öffnung (114, 116) eingebracht ist.

11. Magnetische Abschirmung (110) nach dem vorhergehenden Anspruch, wobei das mindestens eine Abschirmelement (112) mindestens zwei Abschirmelemente (112) umfasst, wobei die Öffnung (114, 116) mindestens einen Verbindungsbereich (116) umfasst, wobei die Abschirmelemente (112) in dem Verbindungsbereich (116) miteinander verbunden sind, wobei zur Verstärkung der magnetischen Abschirmung (110) das magnetische Füllmaterial (118) in den Verbindungsbereich (116) eingebracht ist.

12. Magnetische Abschirmung (110) nach einem der vorhergehenden, eine magnetische Abschirmung (110) betreffenden Ansprüche, wobei die Abschirmelemente (112) mindestens ein metallisches Material umfassen, insbesondere mindestens eines der folgenden Materialien: Eisen; Nickel; eine Legierung mit den Elementen Eisen und Nickel, insbesondere mit einem Nickelanteil zwischen 60% und 90% und besonders bevorzugt zwischen 75% und 80%.

13. Magnetische Abschirmung (110) nach einem der vorhergehenden, eine magnetische Abschirmung (110) betreffenden Ansprüche, wobei die Abschirmelemente (112) eine Permeabilität von mindestens 100 aufweisen.

14. Magnetische Abschirmung (110) nach einem der vorhergehenden, eine magnetische Abschirmung (110) betreffenden Ansprüche, wobei die magnetische Abschirmung (110) einen Innenraum (214) von mindestens 1 m³ umschließt, vorzugsweise einen begehbaren Innenraum (214).

15. Biomagnetisches Messsysteme (210), insbesondere für den Einsatz in der Magnetokardiologie oder der Magnetoneurologie, umfassend mindestens ein magnetisches Sensorsystem (222) zur Erfassung mindestens eines Magnetfeldes, weiterhin umfassen mindestens eine magnetische Abschirmung (110) nach einem der vorhergehenden, eine magnetische Abschirmung (110) betreffenden Ansprüche.

16. Verfahren zur Herstellung einer magnetische Abschirmung (110) nach einem der vorhergehenden, eine magnetische Abschirmung (110) betreffenden Ansprüche, wobei zunächst mindestens zwei Abschirmelemente (112) miteinander mechanisch verbunden werden, wobei der mindestens eine Verbindungsbereich (116) gebildet wird, wobei anschließend das magnetische Füllmaterial (118) in den Verbindungsbereich (116) eingebracht wird.

17. Verfahren zur Herstellung eines magnetischen Füllmaterials (118) nach einem der vorhergehenden, ein magnetisches Füllmaterial (118) betreffenden Ansprüche, umfassend die folgenden Schritte:
- das mindestens eine Matrixmaterial (310) wird bereitgestellt;
- die mindestens eine magnetische Komponente (318) wird in das Matrixmaterial (310) eingemischt.

## Claims

1. Magnetic filling material (118) for bridging interspaces (114, 116) in magnetic shields and for shielding static or low-frequency magnetic fields, wherein the magnetic filling material (118) comprises at least one matrix material (310) and at least one magnetic component (318) embedded into the matrix material (310), wherein the magnetic component (318) has magnetically shielding properties, wherein the magnetic component (318) comprises at least one material having a permeability of at least 100.

2. Magnetic filling material (118) according to the preceding claim, wherein the matrix material (310) has substantially diamagnetic properties.

3. Magnetic filling material (118) according to either of the preceding claims, wherein the matrix material (310) has at least one deformable state and at least one cured state, wherein the matrix material (310) is liquid or has at least partly plastic and/or elastic properties in the deformable state, and wherein the matrix material (310) is substantially rigid in the cured state.

4. Magnetic filling material (118) according to any of the preceding claims, wherein the magnetic component (318) comprises at least one ferromagnetic material, in particular a material having a permeability of at least 300, and particularly preferably of at least 1000.

5. Magnetic filling material (118) according to any of the preceding claims, wherein the magnetic component (318) comprises at least one of the following materials: iron; nickel; an alloy comprising the elements iron and nickel, in particular comprising a nickel fraction of between 60% and 90%, and particularly preferably between 75% and 80%.

6. Magnetic filling material (118) according to any of the preceding claims, wherein the magnetic component (318) is present in powder form or in particle form.

7. Magnetic filling material (118) according to the preceding claim, wherein the magnetic component (318) comprises particles having an average particle size of less than 500 micrometers, in particular less than 90 micrometers, and particularly preferably of 60 micrometers.

8. Magnetic filling material (118) according to any of the preceding claims, wherein the magnetic component (318) comprises a mass fraction of 5 to 50 weight percent, in particular 15 weight percent, of the magnetic filling material (118).

9. Magnetic filling material (118) according to any of the preceding claims, wherein the magnetic component (318) comprises a volume fraction of 1 to 30 volume percent of the magnetic filling material (118).

10. Magnetic shield (110) for shielding static or low-frequency magnetic fields, comprising at least one shielding element (112) having magnetically shielding properties, wherein the shielding element (112) has at least one opening (114, 116), wherein, for reinforcing the magnetic shield (110) at least one magnetic filling material (118) according to any of the preceding claims is introduced into the opening (114, 116).

11. Magnetic shield (110) according to the preceding claim, wherein the at least one shielding element (112) comprises at least two shielding elements (112), wherein the opening (114, 116) comprises at least one connecting region (116), wherein the shielding elements (112) are connected to one another in the connecting region (116), wherein, for reinforcing the magnetic shield (110), the magnetic filling material (118) is introduced into the connecting region (116).

12. Magnetic shield (110) according to any of the preceding claims relating to a magnetic shield (110), wherein the shielding elements (112) comprise at least one metallic material, in particular at least one of the following materials: iron; nickel; an alloy comprising the elements iron and nickel, in particular comprising a nickel fraction of between 60% and 90%, and particularly preferably between 75% and 80%.

13. Magnetic shield (110) according to any of the preceding claims relating to a magnetic shield (110), wherein the shielding elements (112) have a permeability of at least 100.

14. Magnetic shield (110) according to any of the preceding claims relating to a magnetic shield (110), wherein the magnetic shield (110) encloses an interior space (214) of at least 1 m³, preferably an accessible interior space (214).

15. Biomagnetic measurement system (210), in particular for use in magnetocardiology or magnetoneurology, comprising at least one magnetic sensor system (222) for detecting at least one magnetic field, furthermore comprising at least one magnetic shield (110) according to any of the preceding claims relating to a magnetic shield (110).

16. Method for producing a magnetic shield (110) according to any of the preceding claims relating to a magnetic shield (110), wherein firstly at least two shielding elements (112) are mechanically connected to one another, wherein the at least one connecting region (116) is formed, wherein the magnetic filling material (118) is subsequently introduced into the connecting region (116).

17. Method for producing a magnetic filling material (118) according to any of the preceding claims relating to a magnetic filling material (118), comprising the following steps:
- the at least one matrix material (310) is provided;
- the at least one magnetic component (318) is mixed into the matrix material (310)

## Revendications

1. Matériau de remplissage (118) magnétique en vue de franchir des espaces intermédiaires (114, 116) dans des blindages magnétiques et pour blinder des champs magnétiques statiques ou à basse fréquence, le matériau de remplissage (118) magnétique présentant au moins un matériau de matrice (310) et au moins un composant (318) magnétique intégré dans le matériau de matrice (310), le composant (318) magnétique présentant des propriétés de blindage magnétique, le composant (318) magnétique présentant au moins un matériau présentant une perméabilité d'au moins 100.

2. Matériau de remplissage (118) magnétique selon la revendication précédente, le matériau de matrice (310) présentant principalement des propriétés diamagnétiques.

3. Matériau de remplissage (118) magnétique selon l'une des revendications précédentes, le matériau de matrice (310) présentant au moins un état déformable et au moins un état durci, le matériau de matrice (310) étant liquide dans l'état déformable ou présentant des propriétés au moins partiellement plastiques et/ou élastiques et le matériau de matrice (310) étant principalement rigide dans l'état durci.

4. Matériau de remplissage (118) magnétique selon l'une des revendications précédentes, le composant (318) magnétique présentant au moins un matériau ferromagnétique, en particulier un matériau avec une perméabilité d'au moins 300 et avec une préférence particulière d'au moins 1 000.

5. Matériau de remplissage (118) magnétique selon l'une des revendications précédentes, le composant (318) magnétique comprenant au moins l'un des matériaux suivants : fer ; nickel ; un alliage avec les éléments fer et nickel, en particulier avec une fraction de nickel comprise entre 60 % et 90% et avec une préférence particulière entre 75% et 80 %.

6. Matériau de remplissage (118) magnétique selon l'une des revendications précédentes, le composant (318) magnétique étant présent sous forme de poudre ou sous forme de particule.

7. Matériau de remplissage (118) magnétique selon la revendication précédente, le composant (318) magnétique présentant des particules avec une grandeur de particule moyenne de moins de 500 microns, en particulier moins de 90 microns et avec une préférence particulière de 60 microns.

8. Matériau de remplissage (118) magnétique selon l'une des revendications précédentes, le composant (318) magnétique présentant une fraction de masse de 5 à 50 pour cent en poids, en particulier 15 pour cent en poids, du matériau de remplissage (118) magnétique.

9. Matériau de remplissage (118) magnétique selon l'une des revendications précédentes, le composant (318) magnétique présentant une fraction de volume de 1 à 30 pour cent de volume du matériau de remplissage (118) magnétique.

10. Blindage (110) magnétique destiné à blinder des champs magnétiques statiques ou à basse fréquence, comprenant au moins un élément de blindage (112) avec des propriétés de blindage magnétiques, l'élément de blindage (112) présentant au moins une ouverture (114, 116), au moins un matériau de remplissage (118) magnétique selon l'une des revendications précédentes étant introduit dans l'ouverture (114, 116) pour renforcer le blindage magnétique (110).

11. Blindage (110) magnétique selon la revendication précédente, le au moins un élément de blindage (112) comprenant au moins deux éléments de blindage (112), l'ouverture (114, 116) comprenant au moins une zone de liaison (116), les éléments de blindage (112) étant reliés les uns aux autres dans la zone de liaison (116), le matériau de remplissage (118) magnétique étant introduit dans la zone de liaison (116) pour renforcer le blindage (110) magnétique.

12. Blindage (110) magnétique selon l'une des revendications précédentes, concernant un blindage (110) magnétique, les éléments de blindage (112) comprenant au moins un matériau métallique, en particulier au moins l'un des matériaux suivants : fer ; nickel ; un alliage avec les éléments fer et nickel, en particulier avec une fraction de nickel comprise entre 60 % et 90 % et avec une préférence particulière entre 75 % et 80 %.

13. Blindage (110) magnétique selon l'une des revendications précédentes, concernant un blindage (110) magnétique, les éléments de blindage (112) présentant une perméabilité d'au moins 100.

14. Blindage (110) magnétique selon l'une des revendications précédentes, concernant un blindage (110) magnétique, le blindage (110) magnétique comprenant un espace intérieur (214) d'au moins 1 m³, de préférence un espace intérieur (214) praticable.

15. Système de mesure (210) biomagnétique, en particulier pour une utilisation en magnétocardiologie ou en magnétoneurologie, comprenant au moins un système de capteur (222) magnétique pour l'enregistrement d'au moins un champ magnétique, comprenant également au moins un blindage (110) magnétique selon l'une des revendications précédentes, concernant un blindage (110) magnétique.

16. Procédé destiné à fabriquer un blindage (110) magnétique selon l'une des revendications précédentes, concernant un blindage (110) magnétique, au moins deux éléments de blindage (112) étant d'abord reliés mécaniquement l'un à l'autre, la au moins une zone de liaison (116) étant formée, le matériau de remplissage (118) magnétique étant introduit ensuite dans la zone de liaison (116).

17. Procédé destiné à fabriquer un matériau de remplissage (118) magnétique selon l'une des revendications précédentes, concernant un matériau de remplissage (118) magnétique, comprenant les étapes suivantes :
- le au moins un matériau de matrice (310) est mis à disposition ;
- le au moins un composant (318) magnétique est introduit dans le matériau de matrice (310).
